# EUROPÄISCHE PATENTSCHRIFT

(11) **EP 1 785 022 B1**
(45) Veröffentlichungstag und Bekanntmachung des Hinweises auf die Patenterteilung: **21.01.2015**
(21) Anmeldenummer: 05777904.3
(22) Anmeldetag: 17.08.2005
(51) Int. Cl.: H05K 13/04

(54) **BESTÜCKKOPF UND VERFAHREN ZUM BESTÜCKEN VON SUBSTRATEN MIT ELEKTRISCHEN BAUELEMENTEN**
ASSEMBLING HEAD AND METHOD FOR FITTING SUBSTRATES WITH ELECTRIC COMPONENTS
TETE DE PLACEMENT ET PROCEDE PERMETTANT D'EQUIPER DES SUBSTRATS DE COMPOSANTS ELECTRIQUES

(30) Priorität: 01.09.2004 DE 102004042357
(43) Veröffentlichungstag der Anmeldung: 16.05.2007
(73) Patentinhaber: ASM Assembly Systems GmbH & Co. KG, 81379 München (DE)
(72) Erfinder: BURGER, Stefan, D-81379 München (DE)
(74) Vertreter: Patentanwälte Bals & Vogel
(86) Internationale Anmeldenummer: PCT/EP2005/054043
(87) Internationale Veröffentlichungsnummer: WO 2006/024604

(56) Entgegenhaltungen:
- US-A1- 2002 178 578

## Beschreibung

Die Erfindung betrifft einen Bestückkopf zum Bestücken von Substraten mit elektrischen Bauelementen, ein Verfahren zum Abholen elektrischer Bauelemente, ein Verfahren zum Bestücken von Substraten mit elektrischen Bauelementen und ein Verfahren zum Abholen elektrischer Bauelemente und zum Bestücken von Substraten.

Aus der Offenlegungsschrift DE-10236626 oder US-2002/178578 ist ein Bestückkopf, genauer gesagt ein Matrixbestückkopf, bekannt, bei dem mehrere Halteeinrichtungen durch selektive magnetische Ankopplung an ein gemeinsames Hubelement eines zentralen Z-Antriebs entlang einer Z-Achse bewegbar sind. Im ungekoppelten Zustand werden die Halteeinrichtungen durch einen Haltemechanismus in einer oberen Ausgangsposition gehalten.

Der oben erwähnte Bestückkopf hat zum Nachteil, dass die Halteeinrichtungen in einem Zustand, in dem sie nicht an das Hubelement des Z-Antriebs gekoppelt sind, in einer oberen Ausgangsposition, die für alle Halteeinrichtungen gleich ist, gehalten werden. Dadurch muss jede Halteeinrichtung beim Aufnehmen und Abgeben der Bauelemente, unabhängig von der Höhe des jeweils aufzunehmenden oder abzugebenden Bauelements, den gesamten Hub des Z-Antriebs durchfahren. Des Weiteren liegen die Unterkanten aufgenommener Bauelemente unterschiedlicher Höhe in verschiedenen Ebenen. Da die Unterkante jedes Bauelements beim Vermessen in der Fokusebene der Messvorrichtung liegen muss, muss die Lage der Bauteile beim Vermessen korrigiert werden. Beide der zuvor genannten Aspekte bringen zeitliche Nachteile mit sich.

Es ist daher die Aufgabe der vorliegenden Erfindung, einen Bestückkopf und Verfahren zum Abholen elektrischer Bauelemente und zum Bestücken von Substraten zu liefern, mit denen die Bestückeffizienz eines Bestückautomaten gesteigert werden kann.

Diese Aufgabe wird durch den Bestückkopf gemäß Anspruch 1, das Verfahren zum Abholen elektrischer Bauelemente gemäß Anspruch 3, das Verfahren zum Bestücken von Substraten gemäß Anspruch 5 und das Verfahren zum Abholen elektrischer Bauelemente und zum Bestücken von Substraten gemäß Anspruch 7 gelöst.

Bei dem erfindungsgemäßen Bestückkopf nach Anspruch 1 umfasst jede Halteeinrichtung sowohl eine steuerbare Kupplungseinrichtung als auch eine steuerbare Fixiereinrichtung. Mit der steuerbaren Kupplungseinrichtung kann die jeweilige Halteeinrichtung an einer beliebigen Position entlang der Verfahrstrecke mit dem Mitnahmeelement des Antriebs gekoppelt werden und in eine beliebige Zielposition entlang der Verfahrstrecke bewegt werden. Bei Erreichen der Zielposition wird die Kupplungseinrichtung deaktiviert, sodass die jeweilige Halteeinrichtung von dem Mitnahmeelement des Antriebs entkoppelt ist. Die steuerbare Fixiereinrichtung erlaubt es der jeweiligen Halteeinrichtung sich in der Zielposition am Grundkörper des Bestückkopfs festzumachen, sodass die Halteeinrichtung an dieser Position fixiert ist. Die Kupplungseinrichtung und die Fixiereinrichtung sind dabei wechselseitig in Betrieb. Dadurch, dass jede Halteeinrichtung des erfindungsgemäßen Bestückkopfes über jeweils eine steuerbare Kupplungseinrichtung und Fixiereinrichtung verfügt, ermöglicht dies eine höchste Flexibilität hinsichtlich der Positionierung der Halteeinrichtungen entlang der gesamten Verfahrstrecke des Antriebs. Die Halteeinrichtungen können individuell und unabhängig voneinander mit dem Mitnahmeelement gekoppelt oder am Grundkörper fixiert werden. Gerade bei einer Vielfalt von Bauelementen unterschiedlicher Höhe kann somit die Ausgangsposition, die jede Halteeinrichtung vor einem Aufnahme- oder Bestückvorgang einnimmt, individuell an das jeweilige Bauelement angepasst werden, um so möglichst kurze Wege beim Aufnehmen und Bestücken zurücklegen zu müssen. Dadurch kann die Effizienz des Bestückvorgangs deutlich gesteigert werden.

Gemäß Anspruch 2 kann es vorteilhaft sein, dass der Antrieb als Linearmotor ausgebildet ist, dessen Läufer entweder das Mitnahmeelement selbst darstellt oder mit dem Mitnahmeelement fest verbunden ist. Der Linearmotor ermöglicht eine kompakte Bauweise und eine hohe Präzision bei der Positionierung.

Das erfindungsgemäße Verfahren zum Abholen elektrischer Bauelemente gemäß Anspruch 3 bezieht sich auf einen Bestückautomaten, der einen verfahrbaren erfindungsgemäßen Bestückkopf aufweist, wie er oben beschrieben ist. Vor dem Abholen der elektrischen Bauelemente wird der Bestückkopfe zu einem Abholbereich des Bestückautomaten verfahren, in dem die elektrischen Bauelemente bereitgestellt werden, und die Halteeinrichtungen werden jeweils in eine individuelle Aufnahmeposition bewegt. Dazu wird eine erste Halteeinrichtung durch Ankoppeln an das Mitnahmeelement des Antriebs mittels der Kupplungseinrichtung in die vorgegebene, der Halteeinrichtung individuell zugeordnete Aufnahmeposition entlang der Verfahrstrecke bewegt. Die individuelle Aufnahmeposition ist dadurch gekennzeichnet, dass sich die jeweilige Halteeinrichtung um die Höhe des jeweils aufzunehmenden Bauelements und zusätzlich um einen einheitlichen ersten Sicherheitsabstand über einer Störkante des Abholbereichs befindet. Die Störkante ist abhängig von der Gestaltung des Abholbereichs und kann beispielsweise durch eine am Bestückautomaten angebrachte Bauelementezuführeinrichtung vorgegeben sein. Bei einer Form der Bauelementezuführeinrichtung, bei der die Bauelemente in den Taschen eines Transportgurtes bereitgestellt werden, stellt beispielsweise die Oberkante des Transportgurtes oder die Oberkante des Zuführeinrichtungsgehäuses die Störkante dar. Die erste Halteeinrichtung wird mittels der steuerbaren Fixiereinrichtung in dieser individuellen Aufnahmeposition am Grundkörper fixiert. Die Schritte des Bewegens der Halteeinrichtung zu der jeweiligen individuell vorgegebenen Aufnahmeposition und das Fixieren in dieser Aufnahmeposition werden für weitere Halteeinrichtungen durchgeführt, bis alle Halteeinrichtungen, die Bauelemente aufnehmen sollen, in ihrer jeweiligen Aufnahmeposition am Grundkörper positioniert, d.h. fixiert sind. Der für alle Halteeinrichtungen einheitliche erste Sicherheitsabstand ist dabei so zu wählen, dass sich die Halteeinrichtungen so nah als möglich an dem jeweils aufzunehmenden Bauelement, gleichzeitig jedoch weit genug über der Störkante des Abholbereichs befinden, um einerseits einen möglichst kurzen Aufnahmeweg zu gewährleisten und andererseits eine Kollision mit der Störkante des Abholbereichs auszuschließen. Anschließend erfolgt die Aufnahme der elektrischen Bauelemente, indem die Halteeinrichtungen durch Ankoppeln an das Mitnahmeelement zu den jeweiligen Bauelementen abgesenkt werden, die Bauelemente aufnehmen, und wieder zurück in jeweilige Aufnahmeposition bewegt und dort fixiert werden.

Dadurch, dass jede Halteeinrichtung den Aufnahmevorgang von der ihr zugeordneten Aufnahmeposition aus startet und nach der Aufnahme wieder in diese Aufnahmeposition zurückbewegt wird, wird gewährleistet, dass der Aufnahmehub des Antriebs, d.h. der Weg zur Annäherung an das Bauelement ausgehend von der Aufnahmeposition, und der Rückstellhub des Antriebs, d.h. der Weg zurück in die Ausnahmeposition, je Halteeinrichtung identisch sind. Obwohl die Aufnahmehübe der einzelnen Halteeinrichtungen unterschiedlich sein können, wird dadurch verhindert, dass der Antrieb an seinen Anschlag anstößt, was passieren könnte, wenn der Aufnahmehub und der Rückstellhub je Halteeinrichtung unterschiedlich lang wären. Dadurch kann auf zeitraubende Korrekturen der Position des Antriebs während des Aufnahmevorgangs verzichtet werden. Des Weiteren kann der maximale Hub des Antriebs klein gehalten werden und der Antrieb kompakt gestaltet werden.

Gemäß Anspruch 4 kann das Verfahren dahingehend ausgestaltet werden, dass das Bewegen der Halteeinrichtungen in die jeweiligen Aufnahmepositionen und das dortige Fixieren der Halteeinrichtung schon während des Bewegens des Bestückkopfes zum Abholbereich durchgeführt wird. Dadurch ergibt sich ein zusätzlicher Zeitgewinn.

Auch das Verfahren zum Bestücken von Substraten gemäß Anspruch 5 ist auf einen Bestückautomaten mit einem erfindungsgemäßen, verfahrbaren Bestückkopf anzuwenden. Vor dem Bestücken wird der Bestückkopf in einen Bestückbereich des Bestückautomaten verfahren, wo das zu bestückende Substrat bereitgestellt wird, und die Halteeinrichtungen werden jeweils in eine individuelle Abgabeposition bewegt. Dazu wird eine erste Halteeinrichtung durch Aktivierung ihrer Kupplungseinrichtung in die ihr individuell zugeordnete Abgabeposition bewegt und dort mittels der Fixiereinrichtung am Grundkörper des Bestückkopfs fixiert. Die Vorgänge des Bewegens und Fixierens werden für weitere Halteeinrichtungen wiederholt, so lange bis alle bestückenden Halteeinrichtungen in ihren jeweiligen individuellen Abgabepositionen fixiert sind. Die den Halteeinrichtungen individuell zugeordneten Abgabepositionen zeichnen sich dadurch aus, dass sich die Halteeinrichtungen um die Summe der Höhe des höchsten der von den Halteeinrichtungen aufgenommenen Bauelemente, der Höhe des von der jeweiligen Halteeinrichtung aufgenommenen Bauelements und eines einheitlichen zweiten Sicherheitsabstands über einer Störkante des Substrats im unbestückten Zustand befinden. In diesem Zustand liegen die Unterkanten der an den Halteeinrichtungen befindlichen Bauelemente um die Höhe des höchsten der von den Halteeinrichtungen aufgenommenen Bauelemente und zusätzlich um einen einheitlichen zweiten Sicherheitsabstand über der Störkante des Substrats im unbestückten Zustand. Des Weiteren liegen die Unterkanten der an den Halteeinrichtungen befindlichen Bauelemente in der Abgabeposition in einer Ebene. Der für alle Halteeinrichtungen einheitliche zweite Sicherheitsabstand ist dabei so zu wählen, dass sich die Halteeinrichtungen zur Gewährleistung eines möglichst kurzen Bestückwegs so nah als möglich am Substrat, gleichzeitig jedoch zur Vermeidung einer Kollision der von den Halteeinrichtungen getragenen Bauelementen mit den während des Bestückens bereits auf dem Substrat befindlichen Bauelementen weit genug über der Störkante des Substrats, welche durch die Oberkante des Substrats selbst vorgegeben ist, befinden. Anschließend wird das Substrat bestückt, indem die Halteeinrichtungen durch Aktivierung der jeweiligen Kupplungseinrichtungen zum Substrat abgesenkt werden, dort das Bauelement auf dem Substrat absetzen, und schließlich in die zuvor genannte Abgabeposition zurückbewegt und dort fixiert werden.

Dadurch, dass jede Halteeinrichtung den Bestückvorgang von der ihr zugeordneten Abgabeposition aus startet und nach dem Bestücken wieder in diese Abgabeposition bewegt wird, wird gewährleistet, dass der Bestückhub des Antriebs, d.h. der Weg zur Annäherung an das Substrat ausgehend von der Abgabeposition, und der Rückstellhub des Antriebs, d.h. der Weg zurück in die Abgabeposition, des Antriebs je Halteeinrichtung identisch sind. Obwohl die Bestückhübe der einzelnen Halteeinrichtungen unterschiedlich sein können, wird dadurch verhindert, dass der Antrieb an seinen Anschlag anstößt, was passieren könnte, wenn der Bestückhub und der Rückstellhub je Halteeinrichtung unterschiedlich lang wären. Dadurch kann auf zeitraubende Korrekturen der Antriebsposition während des Bestückvorgangs verzichtet werden. Des Weiteren kann der maximale Hub des Antriebs klein gehalten werden und der Antrieb kompakt gestaltet werden.

Gemäß einer vorteilhaften Ausgestaltung des Verfahrens nach Anspruch 6 werden die Halteeinrichtungen schon während des Bewegens des Bestückkopfes zum Bestückbereich in die individuellen Abgabepositionen bewegt und dort fixiert. Dadurch ergibt sich ein weiterer Zeitvorteil.

Bei einem Verfahren zum Abholen elektrischer Bauelemente und zum Bestücken von Substraten gemäß dem Anspruch 7 wird der erfindungsgemäße, bewegliche Bestückkopf vor dem Abholen zu einem Abholbereich des Bestückautomaten bewegt, wo elektrische Bauelemente bereitgestellt werden. Wie bei dem Verfahren zum Abholen elektrischer Bauelemente gemäß Anspruch 3, wird vor dem Abholen eine erste Halteeinrichtung in eine ihr individuell zugeordnete Aufnahmeposition bewegt, indem sie durch Aktivierung der Kupplungseinrichtung an das Mitnahmeelement des Antriebs gekoppelt wird. Sobald die Halteeinrichtung die Aufnahmeposition erreicht hat, wird sie dort mittels der Fixiereinrichtung am Grundkörper des Bestückkopfes fixiert. Nachdem alle Halteeinrichtungen, die Bauelemente aufnehmen sollen, in ihre jeweiligen Aufnahmepositionen bewegt und dort fixiert worden sind, beginnt die Aufnahme der Bauelemente. Dabei werden die Halteeinrichtungen, ausgehend von ihren Aufnahmepositionen, in Richtung der Bauelemente abgesenkt und nach der Aufnahme wieder in die jeweiligen Aufnahmepositionen bewegt und dort fixiert. Bis zu diesem Punkt entspricht das Verfahren nach Anspruch 7 dem Verfahren gemäß Anspruch 3, so dass sich auch hier die Kriterien für die Bestimmung der einzelnen Aufnahmepositionen zu befolgen sind und sich die entsprechenden Vorteile ergeben.

Nach Aufnahme der Bauelemente sind die Halteeinrichtungen wieder in ihren jeweiligen Aufnahmepositionen fixiert, so dass die Unterkanten aller aufgenommenen Bauelemente zwangsläufig in einer Ebene liegen. Dadurch können alle Halteeinrichtungen gleichzeitig durch Ankoppeln an das Mitnahmeelement des Antriebs in eine Messposition bewegt werden, so dass die Unterkanten der Bauelemente in der Fokusebene einer Messvorrichtung des Bestückautomaten liegen. Die Halteeinrichtungen werden in der Messposition fixiert und der Bestückkopf wird zur Messvorrichtung des Bestückautomaten bewegt, wo das Vermessen der Bauelemente durchgeführt wird. Dadurch, dass schon alle Unterkanten der Bauelemente in der Fokusebene der Messvorrichtung liegen, kann der Messvorgang sehr schnell durchgeführt werden. Ein mehrmaliges Justieren der Unterkanten unterschiedlicher Bauelemente in die Fokusebene ist nicht nötig.

Nach dem Vermessen wird der Bestückkopf in den Bestückbereich des Bestückautomaten bewegt, so das Substrat zur Bestückung bereitgestellt wird. Vor dem Bestücken werden die Halteeinrichtungen in eine Abgabeposition bewegt und dort fixiert. Da die Unterkanten der Bauelemente bereits in einer Ebene liegen, kann dies für alle Halteeinrichtungen gleichzeitig durchgeführt werden. Die Abgabeposition ist dabei analog der Erläuterung des Verfahrens nach Anspruch 5 zu wählen. Nach erfolgter Positionierung der Halteeinrichtungen wird das Substrat bestückt, indem die Halteeinrichtungen mittels Koppelung an den Antrieb in Richtung des Substrats abgesenkt und unmittelbar nach dem Bestücken wieder in die jeweilige Abgabeposition bewegt und dort fixiert werden. Auch hier gelten analog die Vorteile des Verfahrens zum Bestücken gemäß Anspruch 5.

Bei dem Verfahren nach Anspruch 7 kann gemäß den Ansprüchen 8, 9 und 10 zusätzlich Zeit eingespart werden, indem das Bewegen und Fixieren der Halteeinrichtungen in ihre Aufnahmepositionen während des Bewegens des Bestückkopfes zum Abholbereich, das Bewegen und Fixieren der Halteeinrichtungen in die Messposition während des Bewegens des Bestückkopfes zur Messvorrichtung, und das Bewegen und das Fixieren der Halteeinrichtungen in der Abgabeposition während des Bewegens des Bestückkopfes zum Bestückbereich durchgeführt werden.

Zur Verminderung des Verschleißes der Kupplungs- und Fixiereinrichtungen ist es gemäß Anspruch 11 vorteilhaft, dass zwischen der Kupplungseinrichtung und der Fixiereinrichtung immer nur dann umgeschaltet wird, wenn der Antrieb in Ruhe ist.

Ein bevorzugtes Ausführungsbeispiel des erfindungsgemäßen Bestückkopfes und des erfindungsgemäßen Verfahrens zum Aufnehmen elektrischer Bauelemente und zum Bestücken von Substraten wird im Folgenden unter Bezugnahme auf die beigefügten Zeichnungen näher beschrieben. Dabei stellen
Figur 1 eine schematische Vorderansicht eines Ausführungsbeispiels des erfindungsgemäßen Bestückkopfes,
Figur 2 eine schematische Seitenansicht des in Figur 1 dargestellten Bestückkopfes, und
Figur 3 den schematischen Ablauf einer vorteilhaften Ausgestaltung des erfindungsgemäßen Verfahrens
dar.

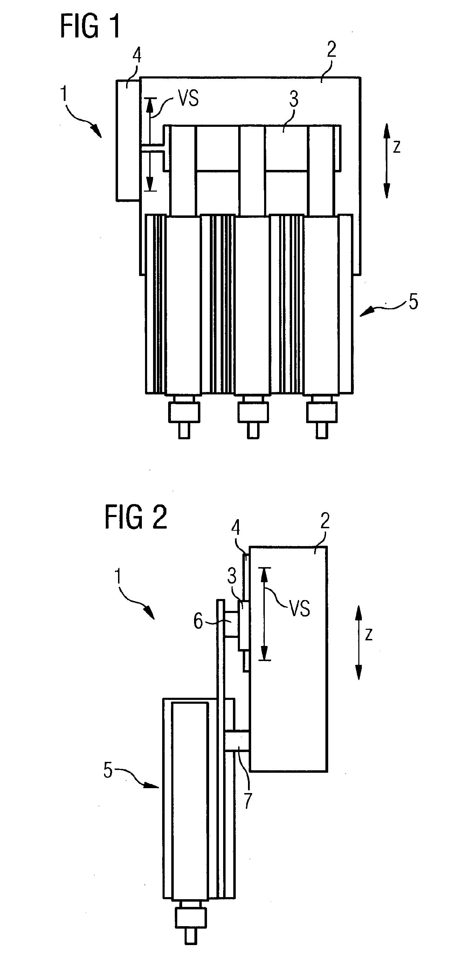

Das in den Figuren 1 und 2 dargestellte Ausführungsbeispiel eines erfindungsgemäßen Bestückkopfes (1) weist einen Grundkörper (2) auf, an dem ein in Z-Richtung (in den Figuren 1 und 2 durch einen Doppelpfeil dargestellt) verschiebbar gelagertes Mitnahmeelement (3) vorgesehen ist. Das Mitnahmeelement (3) ist mit einem am Grundkörper (2) befestigten Antrieb (4) derart verbunden, dass das Mitnahmeelement (3) durch den Antrieb (4) in der Z-Richtung relativ zum Grundkörper (2) entlang einer Verfahrstrecke (VS) bewegt werden kann. Bei dem Mitnahmeelement (3) kann es sich um eine Metallplatte aus ferromagnetischem Material handeln. Der Antrieb (4) kann beispielsweise durch einen Elektromotor mit einer Antriebsspindel als auch durch einen Linearmotor mit einem am Grundkörper (2) befestigten Stator und einem mit dem Mitnahmeelement (3) verbundenen Läufer realisiert werden. Am Bestückkopf (1) sind des Weiteren mehrere Halteeinrichtungen (5) vorgesehen. Bei dem in Figur 1 und 2 dargestellten Ausführungsbeispiel sind die Halteeinrichtungen (5) zeilenartig nebeneinander angeordnet sind. Bei den Halteeinrichtungen (5) kann es sich um mechanische Greifer oder auch um sog. Saugpipetten handeln, an deren Spitzen Saugöffnungen vorgesehen sind, die wahlweise mit Unterdruck oder Überdruck beaufschlagt werden können, um elektrische Bauelemente (8) aufzunehmen oder abzugeben.

Wie aus Figur 2 hervorgeht, ist jede der Halteeinrichtungen (5) mit einer steuerbaren Kupplungseinrichtung (6) und einer steuerbaren Fixiereinrichtung (7) ausgestattet. Bei dem dargestellten Ausführungsbeispiel werden sowohl die Kupplungseinrichtungen (6) als auch die Fixiereinrichtungen (7) durch gesteuerte Elektromagneten realisiert. Jedoch wären auch passive oder steuerbare Reibkupplungen oder piezoelektrisch angetriebene Bremsen als Kupplungs (6)- oder Fixiereinrichtung (7) denkbar. Mittels der steuerbaren Kupplungseinrichtungen (6) können die Halteeinrichtungen (5) an einer beliebigen Position entlang der Verfahrstrecke (VS) des Mitnahmeelements (3) an das Mitnahmeelement (3) gekoppelt und zu einer beliebigen anderen Position entlang der Verfahrstrecke (VS) bewegt werden. Die steuerbaren Fixiereinrichtungen erlauben es den Halteeinrichtungen (5), sich an einer gewünschte Position entlang der Verfahrstrecke (VS) am Grundkörper (2) des Bestückkopfs (1) zu fixieren. Dazu wird der Elektromagnet der Fixiereinrichtung (7) derart angesteuert, dass er am Grundkörper (2), der entweder selbst aus ferromagnetischem Material hergestellt ist oder über eine entsprechende ferromagnetische Platte verfügt, anhaftet. Die Kupplungseinrichtung (6) und die Fixiereinrichtung (7) sind abwechselnd in Betrieb. Bei dem erfindungsgemäßen Bestückkopf (1) können die Halteeinrichtungen (5) einzeln oder in Gruppen zu einer gewünschten Position bewegt und dort fixiert werden. Dies bedeutet eine hohe Flexibilität für die Positionierung der Halteeinrichtungen (5) am Bestückkopf (1). Aus Verschleißgründen ist es vorteilhaft, das Ankoppeln am Mitnahmeelement (3) bzw. am Grundkörper (2) immer nur dann durchzuführen, wenn das Mitnahmeelement (3) bzw. der Antrieb (4) in Ruhe ist.

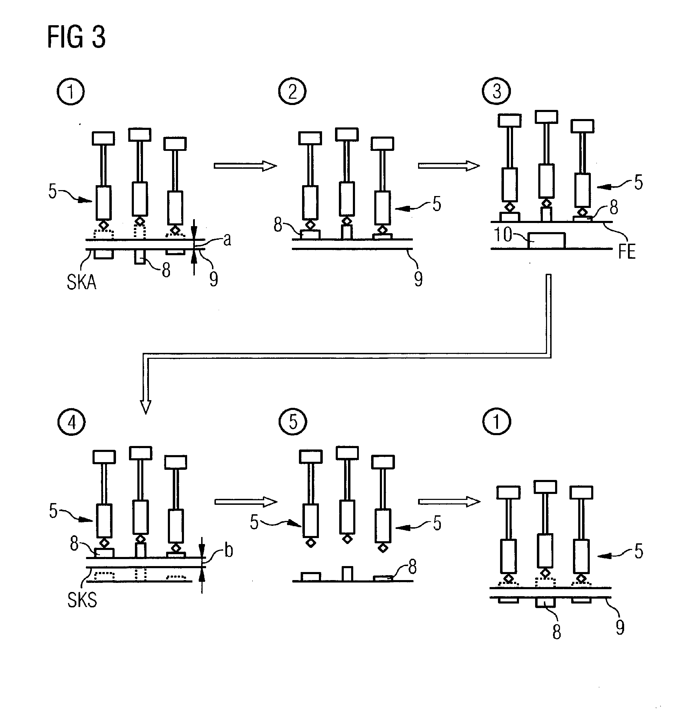

Ein Ausführungsbeispiel des erfindungsgemäßen Verfahrens zum Abholen elektrischer Bauelemente (8) und zum Bestücken von Substraten wird anhand der Figur 3 näher erläutert. In Figur 3 sind die Verfahrensschritte durch Ziffern 1 bis 5 gekennzeichnet. Das Verfahren bezieht sich dabei auf einen Bestückautomaten, welcher über einen erfindungsgemäßen Bestückkopf (1) verfügt, wie er beispielhaft anhand der Figuren 1 und 2 beschrieben wurde. Der Bestückkopf (1) ist dabei parallel zu einer Arbeitsebene des Bestückautomaten verfahrbar.

Im Folgenden wird der in Fig. 3 durch Ziffer 1 gekennzeichnete Verfahrensschritt beschrieben.

Zunächst wird der Bestückkopf (1) zu einem Abholbereich des Bestückautomaten bewegt, wo elektrische Bauelemente (8) von Bauelemente-Zuführeinrichtungen (nicht dargestellt) bereitgestellt werden. Die Zuführeinrichtungen können beispielsweise so ausgebildet sein, dass die Bauelemente (8) durch sog. Transportgurte (9) zum Abholbereich des Bestückautomaten transportiert werden, wo sie von dem Bestückkopf (1) abgeholt werden. Die Bauelemente (8) sind dabei in Taschen des Transportgurtes (9) versenkt angeordnet, wodurch die Oberkanten der Bauelemente (8) in einer Ebene liegen. Gleichzeitig mit dem Bewegen des Bestückkopfes (1) zum Abholbereich wird jede Halteeinrichtung (5) durch Aktivierung ihrer Kupplungseinrichtungen (6) zu einer ihr individuell zugeordneten Aufnahmeposition entlang der Verfahrstrecke (VS) des Mitnahmeelements (3) bewegt und dort durch Aktivierung der Fixiereinrichtung (7) am Grundkörper (2) fixiert. Durch das gleichzeitige Bewegen des Bestückkopfes (1) und der Positionierung der Halteeinrichtungen (5) ergibt sich ein Zeitvorteil, da die Halteeinrichtungen (5) bei Ankunft des Bestückkopfes (1) am Abholbereich bereits zumindest teilweise in ihren Aufnahmepositionen fixiert sind. Die Aufnahmepositionen der einzelnen Halteeinrichtungen (5) sind dabei so festgelegt, dass sich die Halteeinrichtungen (5), genauer gesagt die Unterkante der Halteeinrichtungen (5), um die Höhe des jeweils aufzunehmenden Bauelements und zusätzlich um einen einheitlichen ersten Sicherheitsabstand (a) über einer Störkante (SKA) des Abholbereichs bzw. der Bauelementezuführeinrichtung befindet. In Fig. 3 ist die Störkante des Abholbereichs beispielsweise durch die Oberkante des Transportgurts (9) festgelegt. Je nach Ausführung des Bestückautomaten kann die Störkante jedoch durch andere Abgrenzungen vorgegeben sein, beispielsweise um das Gehäuse der Zuführeinrichtung. Um dem Abstand der Halteeinrichtungen (5) zu den aufzunehmenden elektrischen Bauelementen und damit den vom Antrieb beim Aufnehmen zurückzulegenden Hub möglichst gering zu halten, sollte der erste Sicherheitsabstand möglichst klein gewählt werden. Im besten Fall wird der erste Sicherheitsabstand so gewählt, dass die Unterkante der aufzunehmenden Bauelemente (8) (in Fig. 3 durch gepunktete Bauelemente symbolisiert) knapp über der Störkante (SKA) des Abholbereichs bzw. der Zuführeinrichtung liegt, so dass die Bauelemente (8) gerade nicht mit der Störkante (SKA) kollidieren können.

Im Folgenden wird der in Fig. 3 durch Ziffer 2 gekennzeichnete Verfahrensschritt beschrieben.

Anschließend erfolgt die Aufnahme der Bauelemente (8), wobei die jeweilige Halteeinrichtung (5) durch Ankoppeln an das Mitnahmeelement (3) des Antriebs (4) in Richtung des jeweiligen Bauelements abgesenkt wird, das Bauelement (8) aufnimmt und anschließend in die jeweilige Aufnahmeposition zurückbewegt und dort fixiert wird. Dadurch, dass sich die einzelnen Halteeinrichtungen (5) vor Aufnahme der Bauelemente (8) in ihren oben beschriebenen individuellen Aufnahmepositionen befinden, und nach der Aufnahme wieder in diese Aufnahmeposition zurückbewegt werden, ergeben sich wesentliche Vorteile. Zum einen ist die Aufnahmeposition für jede Halteeinrichtung (5) individuell so gewählt, dass alle Halteeinrichtungen (5) einen möglichst kurzen Weg zur Aufnahme des Bauelements zurücklegen müssen, die Halteeinrichtung (5) jedoch weit genug von der Störkante (SKA) des Abholbereichs entfernt ist, so dass eine Kollision der aufgenommenen Bauelemente mit der Störkante (SKA) ausgeschlossen werden kann. Dadurch, dass jede Halteeinrichtung (5) ausgehend von ihrer Aufnahmeposition zum Bauelement (8) hin bewegt und anschließend wieder in die Aufnahmeposition zurückbewegt wird, ergibt sich je Halteeinrichtung (5) für den Antrieb (4) keine Hubdifferenz, wie es der Fall wäre, wenn sich die Endlage der Halteeinrichtungen (5) von der Aufnahmeposition unterscheiden würde. Dadurch wird verhindert, dass der Antrieb (4) an einen Anschlag anfährt und die Position des Antriebs (4) während der Aufnahme der Bauelemente (8) korrigiert werden muss. Gleichzeitig kann der Antrieb (4) kompakt gehalten werden. Ein weiterer Vorteil ist, dass nach erfolgter Aufnahme die Unterkanten aller aufgenommenen Bauelemente (8) in einer Ebene liegen. Dies ergibt sich zwangsläufig durch die oben beschriebene Festlegung der individuellen Aufnahmepositionen.

Im Folgenden wird der in Fig. 3 durch Ziffer 3 gekennzeichnete Verfahrensschritt beschrieben.

Anschließend wird der Bestückkopf (1) zu einer Messvorrichtung (10) des Bestückautomaten bewegt, wo die Bauelemente (8) vermessen werden. Dabei werden alle Halteeinrichtungen (5) zusammen durch Ankoppeln an das Mitnahmeelement (3) des Antriebs (4) in eine Messposition am Bestückkopf (1) bewegt, so dass die Unterkanten der aufgenommenen Bauelemente (8), welche ja in einer Ebene liegen, in einer Fokusebene (FE) der Messvorrichtung liegen (in Fig. 3 durch Ziffer 3 gekennzeichnet). So können die Bauelemente (8) schnell vermessen werden, ohne dass eine Korrektur der jeweiligen Lage der Bauelemente (8) relativ zur Fokusebene (FE) der Messvorrichtung (10) während des Messvorganges nötig wäre.

Im Folgenden wird der in Fig. 3 durch Ziffer 4 gekennzeichnete Verfahrensschritt beschrieben.

Nach dem Vermessen wird der Bestückkopf (1) zu einem Bestückbereich des Bestückautomaten bewegt, wo das zu bestückende Substrat bereitgestellt wird. Dabei werden die Halteeinrichtungen (5) gemeinsam durch Ankoppeln an das Mitnahmeelement (3) des Antriebs (4) in eine vorgegebene gemeinsame Abgabeposition am Bestückkopf (1) bewegt. Die gemeinsame Abgabeposition der Halteeinrichtungen (5) zeichnet sich dadurch aus, dass sich die Halteeinrichtungen (5) um die Summe der Höhe des höchsten der von den Halteeinrichtungen (5) aufgenommenen Bauelemente (8), der Höhe des von der jeweiligen Halteeinrichtung aufgenommenen Bauelements und eines einheitlichen zweiten Sicherheitsabstands (b) über einer Störkante (SKS) des Substrats im unbestückten Zustand befinden. Oder anders ausgedrückt, liegen die Unterkanten der an den Halteeinrichtungen befindlichen Bauelemente in der Abgabeposition um die Höhe des höchsten der von den Halteeinrichtungen aufgenommenen Bauelemente und zusätzlich um einen einheitlichen zweiten Sicherheitsabstand über der Störkante des Substrats im unbestückten Zustand. Der einheitliche zweite Sicherheitsabstand ist dabei so zu wählen, dass sich die Halteeinrichtungen (5) zur Gewährleistung eines möglichst kurzen Bestückwegs so nah als möglich am Substrat, gleichzeitig jedoch zur Vermeidung einer Kollision der von den Halteeinrichtungen (5) getragenen Bauelementen mit den während des Bestückens auf dem Substrat befindlichen Bauelementen (in Fig. 3 durch gepunktete Bauelemente dargestellt) weit genug über der Störkante (SKS) des Substrats. Die Störkante (SKS) des Substrats ist dabei durch die Oberkante des Substrats im unbestückten Zustand festgelegt.

Im Folgenden wird der in Fig. 3 durch Ziffer 5 gekennzeichnete Verfahrensschritt beschrieben.

Anschließend erfolgt das Bestücken des Substrats, wobei die jeweiligen Halteeinrichtungen durch Aktivierung der Kupplungseinrichtung (6) an das Mitnahmeelement (3) gekoppelt in Richtung des Substrats abgesenkt, um dort die elektrischen Bauelemente (8) abzugeben, und wieder zurück in die Abgabeposition bewegt und dort fixiert werden. Dadurch, dass die Halteeinrichtungen (5) vor dem Bestücken in einer gemeinsamen Abgabeposition fixiert werden und nach dem Bestücken wieder in die Abgabeposition zurückbewegt werden, tritt je Halteeinrichtung (5) kein Hubunterschied des Antriebs (4) auf und es ergeben sich dieselben Vorteile, wie sie oben bei der Aufnahme der Bauelemente (8) erläutert wurden.

Nach erfolgter Bestückung des Substrats wird der Bestückkopf (1) wieder in den Abholbereich des Bestückautomaten verfahren und ein neuer Zyklus beginnt (in Fig. 3 durch Ziffer 1 gekennzeichnet).

Bei dem oben beispielhaft beschriebenen Verfahren können die Verfahrensschritte vom Bewegen des Bestückkopfs (1) (1) zum Abholbereich des Bestückautomaten bis einschließlich des Aufnehmens der Bauelemente (8) als Ausführungsbeispiel eines eigenständiges Verfahrens zu Abholen elektrischer Bauelemente (8) angesehen werden.

Analog können bei dem oben beispielhaft beschriebenen Verfahren die Verfahrensschritte vom Bewegen des Bestückkopfs (1) zum Bestückbereich des Bestückautomaten bis einschließlich des Bestückens der Bauelemente (8) als Ausführungsbeispiel eines eigenständiges Verfahrens zu Bestücken von Substraten mit elektrischen Bauelementen angesehen werden.

Grundsätzlich ist anzumerken, dass zur Verhinderung eines übermäßigen Verschleißes das Ankoppeln der Halteeinrichtungen (5) an dem Mitnahmeelement (3) sowie das Fixieren an dem Grundkörper (2) des Bestückkopfes (1) immer nur dann stattfinden, wenn der Antrieb (4) bzw. das Mitnahmeelement (3) in Ruhe ist.

### Bezugszeichenliste

- 1: Bestückkopf
- 2: Grundkörper
- 3: Mitnahmeelement
- 4: Antrieb
- 5: Haltelement
- 6: Kupplungseinrichtung
- 7: Fixiereinrichtung
- 8: Bauelement
- 9: Transportgurt
- 10: Messvorrichtung

- a: erster Sicherheitsabstand
- b: zweiter Sicherheitsabstand
- VS: Verfahrstrecke
- FE: Fokusebene
- SKA: Störkante des Abholbereichs
- SKS: Störkante des Substrats

## Patentansprüche

1. Bestückkopf (1), insbesondere zum Bestücken von Substraten mit elektrischen Bauelementen, mit
- einem Grundkörper (2)
- mindestens zwei Halteeinrichtungen (5), welche relativ zum Grundkörper (2) entlang einer Verfahrstrecke (VS) in der Bewegungsrichtung verschiebbar gelagert sind,
**dadurch gekennzeichnet, dass** der Bestückkopf umfasst einem Mitnahmeelement (3) für die Halteeinrichtungen, welches mittels eines Antriebs (4) in einer Bewegungsrichtung relativ zum Grundkörper (2) verschiebbar ist, und dass jede Halteeinrichtung (5) eine steuerbare Kupplungseinrichtung (6) zum individuellen Koppeln der jeweiligen Halteeinrichtung (5) an einer beliebigen Position entlang der Verfahrstrecke (VS) mit dem Mitnahmeelement (3), und eine steuerbare Fixiereinrichtung (7) zum individuellen Fixieren der jeweiligen Halteeinrichtung (5) an einer beliebigen Position entlang der Verfahrstrecke (VS) am Grundkörper (2) aufweist.

2. Bestückkopf (1) nach Anspruch 1, **dadurch gekennzeichnet, dass** es sich bei dem Antrieb (4) um einen Linearmotor und bei dem Mitnahmeelement (3) um den Läufer des Linearmotors handelt.

3. Verfahren zum Abholen elektrischer Bauelementen für einen Bestückautomaten mit einem verfahrbaren Bestückkopf (1), der einen Grundkörper (2), ein Mitnahmeelement (3), welches mittels eines Antriebs (4) in einer Bewegungsrichtung relativ zum Grundkörper (2) verschiebbar ist, und mindestens zwei Halteeinrichtungen (5), welche relativ zum Grundkörper (2) entlang einer Verfahrstrecke (VS) in der Bewegungsrichtung verschiebbar gelagert sind, umfasst, wobei jede Halteeinrichtung (5) eine steuerbare Kupplungseinrichtung (6) zum individuellen Koppeln der jeweiligen Halteeinrichtung (5) an einer beliebigen Position entlang der Verfahrstrecke (VS) mit dem Mitnahmeelement (3), und eine steuerbare Fixiereinrichtung (7) zum individuellen Fixieren der jeweiligen Halteeinrichtung (5) an einer beliebigen Position entlang der Verfahrstrecke (VS) am Grundkörper (2) aufweist,
wobei das Verfahren folgende Schritte umfasst
- Bewegen des Bestückkopfs (1) zu einem Abholbereich des Bestückautomaten, in dem die elektrischen Bauelemente (8) bereitgestellt sind;
- Bewegen einer Halteeinrichtung (5) entlang der Verfahrstrecke (VS) in eine vorgegebene Aufnahmeposition, in der sich die Halteeinrichtung (5) um die Höhe des von dieser Halteeinrichtung (5) aufzunehmenden Bauelements (5) und zusätzlich um einen einheitlichen ersten Sicherheitsabstand (a) über einer Störkante (SKA) des Abholbereichs des Bestückautomaten befindet;
- Fixieren der Halteeinrichtung (5) in der Aufnahmeposition;
- Wiederholen der Schritte des Bewegens und des Fixierens der Halteeinrichtung (5) für weitere Halteeinrichtungen (5) des Bestückkopfs (1) bis zumindest die die Bauelemente (8) aufnehmenden Halteeinrichtungen (5) in den jeweiligen Aufnahmepositionen fixiert sind;
- Aufnahme von Bauelementen (8), wobei die jeweiligen Halteeinrichtungen (5) entlang der Verfahrstrecke (VS) in Richtung der Bauelemente (8) abgesenkt und nach der Aufnahme wieder in die jeweilige Aufnahmeposition bewegt und dort fixiert werden.

4. Verfahren nach Anspruch 3, **dadurch gekennzeichnet, dass** das Bewegen der Halteeinrichtungen (5) in die jeweiligen Aufnahmepositionen und das Fixieren der Halteeinrichtungen (5) in den jeweiligen Aufnahmepositionen während des Bewegens des Bestückkopfs (1) zum Abholbereich durchgeführt wird.

5. Verfahren zum Bestücken von Substraten mit elektrischen Bauelementen für einen Bestückautomaten mit einem verfahrbaren Bestückkopf (1), der einen Grundkörper (2), ein Mitnahmeelement (3), welches mittels eines Antriebs (4) in einer Bewegungsrichtung relativ zum Grundkörper (2) verschiebbar ist, und mindestens zwei Halteeinrichtungen (5), welche relativ zum Grundkörper (2) entlang einer Verfahrstrecke (VS) in der Bewegungsrichtung verschiebbar gelagert sind, umfasst, wobei jede Halteeinrichtung (5) eine steuerbare Kupplungseinrichtung (6) zum individuellen Koppeln der jeweiligen Halteeinrichtung (5) an einer beliebigen Position entlang der Verfahrstrecke (VS) mit dem Mitnahmeelement (3), und eine steuerbare Fixiereinrichtung (7) zum individuellen Fixieren der jeweiligen Halteeinrichtung (5) an einer beliebigen Position entlang der Verfahrstrecke (VS) am Grundkörper (2) aufweist, wobei das Verfahren folgende Schritte umfasst
- Bewegen des Bestückkopfes (1) mit den von den Halteeinrichtungen (5) aufgenommenen elektrischen Bauelementen (8) in einen Bestückbereich des Bestückautomaten, wo ein Substrat zur Bestückung mit den elektrischen Bauelementen (8) bereitgestellt ist;
- Bewegen einer Halteeinrichtung (5) entlang der Verfahrstrecke (VS) in eine vorgegebene Abgabeposition, in der sich die Halteeinrichtung (5) um die Summe der Höhe des höchsten der von den Halteeinrichtungen (5) aufgenommenen Bauelemente (8), der Höhe des von der jeweiligen Halteeinrichtung aufgenommenen Bauelements und eines einheitlichen zweiten Sicherheitsabstands (b) über einer Störkante (SKS) des Substrats im unbestückten Zustand befindet;
- Fixieren der Halteeinrichtung (5) in der Abgabeposition;
- Wiederholen der Schritte des Bewegens und des Fixierens der Halteeinrichtung (5) für weitere Halteeinrichtungen (5) des Bestückkopfs (1) bis zumindest die Bauelemente (8) haltenden Halteeinrichtungen (5) in den jeweiligen Abgabepositionen fixiert sind;
- Bestücken des Substrats, wobei die jeweiligen Halteeinrichtungen (5) entlang der Verfahrstrecke (VS) in Richtung des Substrats abgesenkt und nach dem Bestücken wieder in die jeweilige Abgabeposition bewegt und dort fixiert werden.

6. Verfahren nach der Anspruch 5, **dadurch gekennzeichnet, dass** das Bewegen der Halteeinrichtungen (5) in die jeweiligen Abgabepositionen und das Fixieren der Halteeinrichtungen (5) in den jeweiligen Abgabepositionen während des Bewegens des Bestückkopfs (1) zum Bestückbereich durchgeführt wird.

7. Verfahren zum Abholen elektrischer Bauelemente (8) und zum Bestücken von Substraten mit den elektrischen Bauelementen für einen Bestückautomaten mit einem verfahrbaren Bestückkopf (1), der einen Grundkörper (2), ein Mitnahmeelement (3), welches mittels eines Antriebs (4) in einer Bewegungsrichtung relativ zum Grundkörper (2) verschiebbar ist, und mindestens zwei Halteeinrichtungen (5), welche relativ zum Grundkörper (2) entlang einer Verfahrstrecke (VS) in der Bewegungsrichtung verschiebbar gelagert sind, umfasst, wobei jede Halteeinrichtung (5) eine steuerbare Kupplungseinrichtung (6) zum individuellen Koppeln der jeweiligen Halteeinrichtung (5) an einer beliebigen Position entlang der Verfahrstrecke (VS) mit dem Mitnahmeelement (3), und eine steuerbare Fixiereinrichtung (7) zum individuellen Fixieren der jeweiligen Halteeinrichtung (5) an einer beliebigen Position entlang der Verfahrstrecke (VS) am Grundkörper (2) aufweist,
wobei das Verfahren folgende Schritte umfasst
- Bewegen des Bestückkopfs (1) zu einem Abholbereich des Bestückautomaten, in dem die elektrischen Bauelemente (8) bereitgestellt sind;
- Bewegen einer Halteeinrichtung (5) entlang der Verfahrstrecke (VS) in eine vorgegebene Aufnahmeposition, in der sich die Halteeinrichtung (5) um die Höhe des von dieser Halteeinrichtung (5) aufzunehmenden Bauelements (8) und zusätzlich um einen einheitlichen ersten Sicherheitsabstand (a) über einer Störkante (SKA) des Abholbereichs des Bestückautomaten befindet;
- Fixieren der Halteeinrichtung (5) in der Aufnahmeposition;
- Wiederholen der Schritte des Bewegens und des Fixierens der Halteeinrichtung (5) für weitere Halteeinrichtungen (5) des Bestückkopfs (1) bis zumindest die die Bauelemente (8) aufnehmenden Halteeinrichtungen (5) in den jeweiligen Aufnahmepositionen fixiert sind;
- Aufnahme von Bauelementen (8), wobei die Halteeinrichtungen (5) entlang der Verfahrstrecke (VS) in Richtung der Bauelemente (8) abgesenkt werden und nach der Aufnahme wieder in die jeweilige Aufnahmeposition bewegt und dort fixiert werden.
- Bewegen der Halteeinrichtungen (5) relativ zum Grundkörper (2) in eine Messposition, in der die Unterkanten der aufgenommenen Bauteile in einer Fokusebene (FE) einer Messvorrichtung (10) des Bestückautomaten liegen;
- Fixieren der Halteeinrichtungen in der Messposition;
- Bewegen des Bestückkopfs (1) zu einer Messvorrichtung (10) des Bestückautomaten und dortiges Vermessen der Bauteile;
- Bewegen des Bestückkopfs (1) in einen Bestückbereich des Bestückautomaten, wo ein Substrat zur Bestückung mit den elektrischen Bauelementen bereitgestellt wird.
- Bewegen der Halteeinrichtungen (5) entlang der Verfahrstrecke (VS) in eine vorgegebene Abgabeposition, in der sich die Halteeinrichtungen (5) um die Summe der Höhe des höchsten der von den Halteeinrichtungen (5) aufgenommenen Bauelemente (8), der Höhe des von der jeweiligen Halteeinrichtung aufgenommenen Bauelements und eines einheitlichen zweiten Sicherheitsabstands (b) über einer Störkante (SKS) des Substrats im unbestückten Zustand befinden;
- Fixieren der Halteeinrichtungen (5) in der Abgabeposition;
- Bestücken des Substrats, wobei die Halteeinrichtungen (5) entlang der Verfahrstrecke (VS) in Richtung des Substrats abgesenkt werden nach dem Bestücken wieder in die Abgabeposition bewegt und dort fixiert werden.

8. Verfahren nach Anspruch 7, **dadurch gekennzeichnet, dass** das Bewegen der Halteeinrichtungen (5) in die Aufnahmeposition und das Fixieren der Halteeinrichtungen (5) in der Aufnahmeposition während des Bewegens des Bestückkopfs (1) zum Abholbereich durchgeführt wird.

9. Verfahren nach einem der Ansprüche 7 bis 8, **dadurch gekennzeichnet, dass** das Bewegen der Halteeinrichtungen (5) in die Messposition und das Fixieren der Halteeinrichtungen (5) in der Messposition während des Bewegens des Bestückkopfs (1) zur Messvorrichtung durchgeführt wird.

10. Verfahren nach einem der Ansprüche 7 bis 9, **dadurch gekennzeichnet, dass** das Bewegen der Halteeinrichtungen (5) in die Abgabeposition und das Fixieren der Halteeinrichtungen (5) in der Abgabeposition während des Bewegens des Bestückkopfs (1) zum Bestückbereich durchgeführt werden.

11. Verfahren nach einem der Ansprüche 3 bis 10, **dadurch gekennzeichnet, dass** ein Umschalten zwischen der Kupplungseinrichtung (6) und der Fixiereinrichtung (7) immer nur dann durchgeführt wird, wenn der der Antrieb (4) in Ruhe ist.

## Claims

1. A pick-and-place head (1), in particular for the placement of electrical components on substrates, with
- a base body (2)
- at least two holding devices (5), which are mounted displaceably relative to the base body (2) along a traversing section (VS) in the direction of motion,
**characterised in that** the pick-and-place head (1) comprises a driving element (3) for the holding devices (5), which is displaceable by means of a drive (4) in a direction of motion relative to the base body (2), and that each holding device (5) comprises a controllable coupling device (6) for the individual coupling of the respective holding device (5) with the driving element (3) at an arbitrary position along the traversing section (VS) and a controllable fixing device (7) for the individual fixing of the respective holding device (5) to the base body (2) at an arbitrary position along the traversing section (VS).

2. The pick-and-place head (1) according to claim 1, **characterised in that** the drive (4) is a linear motor and the driving element (3) is the rotor of the linear motor.

3. A method for picking up electrical components for an pick-and-place machine with a traversable pick-and-place head (1), which comprises a base body (2), a driving element (3), which is displaceable by means of a drive (4) in a direction of motion relative to the base body (2), and at least two holding devices (5), which are mounted displaceably relative to the base body (2) along a traversing section (VS) in the direction of motion, wherein each holding device (5) comprises a controllable coupling device (6) for the individual coupling of the respective holding device (5) with the driving element (3) at an arbitrary position along the traversing section (VS) and a controllable fixing device (7) for the individual fixing of the respective holding device (5) to the base body (2) at an arbitrary position along the traversing section (VS),
wherein the method comprises the following steps:
- moving the pick-and-place head (1) to a pick-up region of the pick-and-place machine, in which the electrical components (8) are made available;
- moving a holding device (5) along the traversing section (VS) into a preselected pick-up position, in which the holding device (5) is located at the height of the component (8) to be picked up by this holding device (5) and additionally at a uniform first safety distance (a) above an interfering edge (SKA) of the pick-up region of the pick-and-place machine;
- fixing of the holding device (5) in the pick-up position;
- repetition of the steps of moving and fixing the holding device (5) for further holding devices (5) of the pick-and-place head (1) until at least the holding devices (5) picking up the component (8) are fixed in the respective pick-up positions;
- picking-up of components (8), wherein the respective holding devices (5) are lowered along the traversing section (VS) in the direction of the component (8) and, after the picking-up, are moved back into the respective pick-up position and fixed there.

4. The method according to claim 3, **characterised in that** the moving of the holding devices (5) into the respective pick-up positions and the fixing of the holding devices (5) in the respective pick-up positions is carried out during the movement of the pick-and-place head (1) towards the pick-up region.

5. A method for the placement of electrical components on substrates for an pick-and-place machine with a traversable pick-and-place head (1), which comprises a base body (2), a driving element (3), which is displaceable by means of a drive (4) in a direction of motion relative to the base body (2), and at least two holding devices (5), which are mounted displaceably relative to the base body (2) along a traversing section (VS) in the direction of motion, wherein each holding device (5) comprises a controllable coupling device (6) for the individual coupling of the respective holding device (5) with the driving element (3) at an arbitrary position along the traversing section (VS) and a controllable fixing device (7) for the individual fixing of the respective holding device (5) to the base body (2) at an arbitrary position along the traversing section (VS), wherein the method comprises the following steps:
- moving the pick-and-place head (1) with the electrical components (8) picked up by the holding devices (5) into a placement region of the pick-and-place machine, where a substrate is made available for the placement of the electrical components (8);
- moving a holding device (5) along the traversing section (VS) into a preselected placement position, in which the holding device (5) is located at the sum of the height of the highest component (8) picked up by the holding devices (5), the height of the component (8) picked up by the respective holding device and a uniform second safety distance (b) above an interfering edge (SKS) of the substrate in the state without a placement thereon;
- fixing of the holding device (5) in the placement position;
- repetition of the steps of moving and fixing the holding device (5) for further holding devices (5) of the pick-and-place head (1) until at least the holding devices (5) holding the component (8) are fixed in the respective placement positions;
- placement on the substrate, wherein the respective holding devices (5) are lowered along the traversing section (VS) in the direction of the substrate and, after the placement has taken place, are moved back into the respective placement position and fixed there.

6. The method according to claim 5, **characterised in that** the moving of the holding devices (5) into the respective placement positions and the fixing of the holding devices (5) in the respective placement positions is carried out during the movement of the pick-and-place head (1) towards the placement region.

7. A method for picking up electrical components (8) and for the placement of the electrical components (8) on substrates for an pick-and-place machine with a traversable pick-and-place head (1), which comprises a base body (2), a driving element (3), which is displaceable by means of a drive (4) in a direction of motion relative to the base body (2), and at least two holding devices (5), which are mounted displaceably relative to the base body (2) along a traversing section (VS) in the direction of motion, wherein each holding device (5) comprises a controllable coupling device (6) for the individual coupling of the respective holding device (5) with the driving element (3) at an arbitrary position along the traversing section (VS) and a controllable fixing device (7) for the individual fixing of the respective holding device (5) to the base body (2) at an arbitrary position along the traversing section (VS),
wherein the method comprises the following steps:
- moving the pick-and-place head (1) to a pick-up region of the pick-and-place machine, in which the electrical components (8) are made available;
- moving a holding device (5) along the traversing section (VS) into a preselected pick-up position, in which the holding device (5) is located at the height of the component (8) to be picked up by this holding device (5) and additionally at a uniform first safety distance (a) above an interfering edge (SKA) of the pick-up region of the pick-and-place machine;
- fixing of the holding device (5) in the pick-up position;
- repetition of the steps of moving and fixing the holding device (5) for further holding devices (5) of the pick-and-place head (1) until at least the holding devices (5) picking up the component (8) are fixed in the respective pick-up positions;
- picking-up of components (8), wherein the holding devices (5) are lowered along the traversing section (VS) in the direction of the component (8) and, after the picking-up, are moved back into the respective pick-up position and fixed there;
- moving of the holding devices (5) relative to the base body (2) into a measurement position, in which the lower edges of the picked-up component (8) lie in a focus plane (FE) of a measurement device (10) of the pick-and-place machine;
- fixing of the holding devices in the measurement position;
- moving of the pick-and-place head (1) to a measurement device (10) of the pick-and-place machine and measurement there of the component;
- moving of the pick-and-place head (1) into a placement region of the pick-and-place machine, where a substrate is made available for placement of the electrical components;
- moving of the holding devices (5) along the traversing section (VS) into a preselected placement position, in which the holding devices (5) are located at the sum of the height of the highest component (8) picked up by the holding devices (5), the height of the component (8) picked up by the respective holding device and a uniform second safety distance (b) above an interfering edge (SKS) of the substrate in the state without a placement thereon;
- fixing of the holding devices (5) in the placement position;
- placement on the substrate, wherein the holding devices (5) are lowered along the traversing section (VS) in the direction of the substrate and, after the placement has taken place, are moved back into the placement position and fixed there.

8. The method according to claim 7, **characterised in that** the moving of the holding devices (5) into the pick-up position and the fixing of the holding devices (5) in the pick-up position is carried out during the movement of the pick-and-place head (1) towards the pick-up region.

9. The method according to any one of claims 7 to 8, **characterised in that** the moving of the holding devices (5) into the measurement position and the fixing of the holding devices (5) in the measurement position is carried out during the movement of the pick-and-place head (1) towards the measurement device.

10. The method according to any one of claims 7 to 9, **characterised in that** the moving of the holding devices (5) into the placement position and the fixing of the holding devices (5) in the placement position is carried out during the movement of the pick-and-place head (1) towards the placement region.

11. The method according to any one of claims 3 to 10, **characterised in that** the switch-over between the coupling device (6) and the fixing device (7) is always carried out only when the drive (4) is at rest.

## Revendications

1. Tête d'équipement (1), en particulier pour équiper des substrats avec des composants électriques, avec
- un corps de base (2),
- au moins deux dispositifs de retenue (5) qui sont montés de manière à pouvoir se déplacer par rapport au corps de base (2) le long d'un trajet de déplacement (VS) dans la direction de déplacement,
**caractérisée en ce que** la tête d'équipement (1) comprend un élément d'entraînement (3) pour les dispositifs de retenue (5), lequel peut être déplacé à l'aide d'un mécanisme d'entraînement (4) dans une direction de déplacement par rapport au corps de base (2), et
**en ce que** chaque dispositif de retenue (5) présente un dispositif de couplage contrôlable (6) pour le couplage individuel du dispositif de retenue (5) respectif à l'élément d'entraînement (3) dans une position quelconque le long du trajet de déplacement (VS), et un dispositif de fixation contrôlable (7) pour la fixation individuelle du dispositif de retenue (5) respectif au corps de base (2) dans une position quelconque le long du trajet de déplacement (VS).

2. Tête d'équipement (1) selon la revendication 1, **caractérisée en ce que**, concernant le mécanisme d'entraînement (4), il s'agit d'un moteur linéaire, et concernant l'élément d'entraînement (3), du rotor du moteur linéaire.

3. Procédé pour prendre des composants électriques pour un automate d'équipement avec une tête d'équipement (1) déplaçable, laquelle comprend un corps de base (2), un élément d'entraînement (3) pouvant se déplacer à l'aide d'un mécanisme d'entraînement (4) dans une direction de déplacement par rapport au corps de base (2), et au moins deux dispositifs de retenue (5) montés de manière à pouvoir se déplacer par rapport au corps de base (2) le long d'un trajet de déplacement (VS) dans la direction de déplacement, dans lequel chaque dispositif de retenue (5) présente un dispositif de couplage contrôlable (6) pour le couplage individuel du dispositif de retenue (5) respectif à l'élément d'entraînement (3) dans une position quelconque le long du trajet de déplacement (VS), et un dispositif de fixation contrôlable (7) pour la fixation individuelle du dispositif de retenue (5) respectif sur le corps de base (2) dans une position quelconque le long du trajet de déplacement (VS),
dans lequel le procédé comprend les étapes suivantes:
- déplacement de la tête d'équipement (1) vers une zone de prise de l'automate d'équipement dans laquelle les composants électriques (8) sont mis à disposition;
- déplacement d'un dispositif de retenue (5) le long du trajet de déplacement (VS) dans une position de réception prescrite dans laquelle le dispositif de retenue (5) se trouve de l'ordre de la hauteur du composant (8) à réceptionner par ce dispositif de retenue (5), et additionnellement de l'ordre d'une première distance de sécurité (a) uniforme, au-dessus d'une arête de perturbation (SKA) de la zone de prise de l'automate d'équipement;
- fixation du dispositif de retenue (5) dans la position de réception;
- répétition des étapes de déplacement et de fixation du dispositif de retenue (5) pour d'autres dispositifs de retenue (5) de la tête d'équipement (1) jusqu'à ce que au moins les dispositifs de retenue (5) réceptionnant les composants (8) soient fixés dans les positions de réception respectives;
- réception de composants (8), les dispositifs de retenue (5) respectifs étant abaissés le long du trajet de déplacement (VS) en direction des composants (8), et après la réception, étant de nouveau déplacés dans la position de réception respective et y étant fixés.

4. Procédé selon la revendication 3, **caractérisé en ce que** le déplacement des dispositifs de retenue (5) dans les positions de réception respectives et la fixation des dispositifs de retenue (5) dans les positions de réception respectives sont effectués pendant le déplacement de la tête d'équipement (1) vers la zone de prise.

5. Procédé pour l'équipement de substrats avec des composants électriques pour un automate d'équipement avec une tête d'équipement (1) déplaçable, laquelle comprend un corps de base (2), un élément d'entraînement (3) pouvant se déplacer à l'aide d'un mécanisme d'entraînement (4) dans une direction de déplacement par rapport au corps de base (2), et au moins deux dispositifs de retenue (5), lesquels sont montés de manière à pouvoir se déplacer par rapport au corps de base (2) le long d'un trajet de déplacement (VS) dans la direction de déplacement, dans lequel chaque dispositif de retenue (5) présente un dispositif de couplage contrôlable (6) pour le couplage individuel du dispositif de retenue (5) respectif à l'élément d'entraînement (3) dans une position quelconque le long du trajet de déplacement (VS), et un dispositif de fixation contrôlable (7) pour la fixation individuelle du dispositif de retenue (5) respectif au corps de base (2) dans une position quelconque le long du trajet de déplacement (VS), dans lequel le procédé comprend les étapes suivantes:
- déplacement de la tête d'équipement (1) avec les composants électriques (8) réceptionnés par les dispositifs de retenue (5) dans une zone d'équipement de l'automate d'équipement où un substrat est mis à disposition pour l'équipement avec les composants électriques (8);
- déplacement d'un dispositif de retenue (5) le long du trajet de déplacement (VS) dans une position de délivrance prescrite dans laquelle le dispositif de retenue (5) se trouve de l'ordre de la somme de la hauteur du plus haut des composants (8) prélevés par les dispositifs de retenue (5), de la hauteur du composant réceptionné par le dispositif de retenue respectif et de l'ordre d'une deuxième distance de sécurité (b) uniforme, au-dessus d'une arête de perturbation (SKS) du substrat à l'état non équipé;
- fixation du dispositif de retenue (5) dans la position de délivrance;
- répétition des étapes de déplacement et de fixation du dispositif de retenue (5) pour d'autres dispositifs de retenue (5) de la tête d'équipement (1) jusqu'à ce que au moins les dispositifs de retenue (5) tenant les composants (8) soient fixés dans les positions de délivrance respectives;
- équipement du substrat, les dispositifs de retenue (5) respectifs étant abaissés le long du trajet de déplacement (VS) en direction du substrat, et après l'équipement, étant de nouveau déplacés dans la position de délivrance respective et y étant fixés.

6. Procédé selon la revendication 5, **caractérisé en ce que** le déplacement des dispositifs de retenue (5) dans les positions de délivrance respectives et la fixation des dispositifs de retenue (5) dans les positions de délivrance respectives sont effectués pendant le déplacement de la tête d'équipement (1) vers la zone d'équipement.

7. Procédé pour prendre des composants électriques (8) et pour équiper des substrats avec les composants électriques (8) pour un automate d'équipement avec une tête d'équipement (1) déplaçable, laquelle comprend un corps de base (2), un élément d'entraînement (3) pouvant être déplacé à l'aide d'un mécanisme d'entraînement (4) dans une direction de déplacement par rapport au corps de base (2), et au moins deux dispositifs de retenue (5), lesquels sont montés de manière à pouvoir se déplacer par rapport au corps de base (2) le long d'un trajet de déplacement (VS) dans la direction de déplacement, dans lequel chaque dispositif de retenue (5) présente un dispositif de couplage contrôlable (6) pour le couplage individuel du dispositif de retenue (5) respectif à l'élément d'entraînement (3) dans une position quelconque le long du trajet de déplacement (VS), et un dispositif de fixation contrôlable (7) pour la fixation individuelle du dispositif de retenue (5) respectif au corps de base (2) dans une position quelconque le long du trajet de déplacement (VS),
dans lequel le procédé comprend les étapes suivantes:
- déplacement de la tête d'équipement (1) vers une zone de prise de l'automate d'équipement dans laquelle les composants électriques (8) sont mis à disposition;
- déplacement d'un dispositif de retenue (5) le long du trajet de déplacement (VS) dans une position de réception prescrite dans laquelle le dispositif de retenue (5) se trouve de l'ordre de la hauteur du composant (8) à réceptionner par ce dispositif de retenue (5), et additionnellement de l'ordre d'une première distance de sécurité (a) uniforme, au-dessus d'une arête de perturbation (SKA) de la zone de prise de l'automate d'équipement;
- fixation du dispositif de retenue (5) dans la position de réception;
- répétition des étapes de déplacement et de fixation du dispositif de retenue (5) pour d'autres dispositifs de retenue (5) de la tête d'équipement (1) jusqu'à ce que au moins les dispositifs de retenue (5) réceptionnant les composants (8) soient fixés dans la position de réception respective;
- réception de composants (8), les dispositifs de retenue (5) étant abaissés le long du trajet de déplacement (VS) en direction des composants (8), et après la réception, étant de nouveau déplacés dans la position de réception respective et y étant fixés;
- déplacement des dispositifs de retenue (5) par rapport au corps de base (2) dans une position de mesure dans laquelle les arêtes inférieures des composants réceptionnés se situent dans un plan focal (FE) d'un dispositif de mesure (10) de l'automate d'équipement;
- fixation des dispositifs de retenue dans la position de mesure;
- déplacement de la tête d'équipement (1) vers un dispositif de mesure (10) de l'automate d'équipement et mesure des composants à cet endroit;
- déplacement de la tête d'équipement (1) dans une zone d'équipement de l'automate d'équipement où un substrat est mis à disposition pour l'équipement avec les composants électriques;
- déplacement des dispositifs de retenue (5) le long du trajet de déplacement (VS) dans une position de délivrance prescrite dans laquelle les dispositifs de retenue(5) se trouvent de l'ordre de la somme de la hauteur du plus haut des composants (8) réceptionnés par les dispositifs de retenue (5), de la hauteur du composant réceptionné par le dispositif de retenue respectif et de l'ordre d'une deuxième distance de sécurité (b) uniforme, au-dessus d'une arête de perturbation (SKS) du substrat à l'état non équipé;
- fixation des dispositifs de retenue (5) dans la position de délivrance;
- équipement du substrat, les dispositifs de retenue (5) étant abaissés le long du trajet de déplacement (VS) en direction du substrat, et après l'équipement, étant de nouveau déplacés dans la position de délivrance et y étant fixés.

8. Procédé selon la revendication 7, **caractérisé en ce que** le déplacement des dispositifs de retenue (5) dans la position de réception et la fixation des dispositifs de retenue (5) dans la position de réception sont effectués pendant le déplacement de la tête d'équipement (1) vers la zone de prise.

9. Procédé selon l'une des revendications 7 à 8, **caractérisé en ce que** le déplacement des dispositifs de retenue (5) dans la position de mesure et la fixation des dispositifs de retenue (5) dans la position de mesure sont effectués pendant le déplacement de la tête d'équipement (1) vers le dispositif de mesure.

10. Procédé selon l'une des revendications 7 à 9, **caractérisé en ce que** le déplacement des dispositifs de retenue (5) dans la position de délivrance et la fixation des dispositifs de retenue (5) dans la position de délivrance sont effectués pendant le déplacement de la tête d'équipement (1) vers la zone d'équipement.

11. Procédé selon l'une des revendications 3 à 10, **caractérisé en ce qu'**une commutation entre le dispositif de couplage (6) et le dispositif de fixation (7) est toujours effectuée seulement lorsque le mécanisme d'entraînement (4) est au repos.
